# FASCICULE DE BREVET EUROPEEN

(11) **EP 2 187 227 B1**
(45) Date de publication et mention de la délivrance du brevet: **12.09.2018**
(21) Numéro de dépôt: 09176117.1
(22) Date de dépôt: 16.11.2009
(51) Int. Cl.: G01R 31/28, G08B 29/16, H01H 9/16, B61L 1/20, B61L 27/00, G01R 31/327, G01R 31/00

(54) **Système à sécurité intrinsèque et module de test, notamment pour une utilisation dans un système de signalisation ferroviaire**
Eigensicheres System und Testmodul, insbesondere zur Verwendung in einem Eisenbahn-Signalsystem
System with intrinsic safety and test module, in particular for use in a railway signalling system

(30) Priorité: 18.11.2008 FR 0806446
(43) Date de publication de la demande: 19.05.2010
(73) Titulaire: Thales, 92400 Courbevoie (FR)
(72) Inventeur: Imhoff, Richard, 75013 Paris (FR)
(74) Mandataire: Lucas, Laurent Jacques

(56) Documents cités:
- EP-A- 0 051 907
- EP-A- 0 509 920
- EP-A- 1 139 361
- EP-A- 1 933 443
- US-A- 5 063 374
- US-A- 5 909 660

## Description

La présente invention concerne un système à sécurité intrinsèque et concerne également un module de test. Elle s'applique notamment à des dispositifs de signalisation ferroviaire.

Les systèmes à sécurité intrinsèque sont nécessaires dans tous les dispositifs où le dysfonctionnement de l'un de leurs composants ou circuits peut avoir des conséquences sur la sécurité de personnes. C'est le cas pour des dispositifs utilisés dans des applications telles que la signalisation ferroviaire, mais aussi dans l'instrumentation aéronautique, l'instrumentation de contrôle de centrales nucléaires, d'équipement utilisé dans l'industrie de la pétrochimie, dans l'instrumentation médicale, etc. Dans de tels dispositifs, aucune anomalie, quelle qu'elle soit, ne doit entraîner la transmission d'une information plus permissive que celle prévue en fonctionnement normal. Ainsi, il est nécessaire que les équipements mis en oeuvre puissent assurer leurs fonctions sans que les caractéristiques de sécurité des composants qui les constituent ne puissent être remises en question. A cette fin, des normes applicables aux dispositifs de sécurité existent, telles que la norme IEC 61508 - "Systèmes instrumentés de sécurité", ou bien pour l'exemple spécifique des équipements ferroviaires, la norme EN 50129 - "Système électronique de sécurité pour la signalisation".

Il est notamment nécessaire, dans le cas de dispositifs électroniques, que toute défaillance d'un quelconque composant essentiel puisse être diagnostiquée dans les meilleurs délais, afin que des actions idoines soient mises en oeuvre. A cet effet, il est possible de pratiquer des tests périodiques des dispositifs. Néanmoins de tels tests ont souvent l'inconvénient d'être intrusifs, dans le sens où ils requièrent l'alimentation en énergie d'entrées ou de sorties du dispositif ou de certains de ses composants. En outre, il est indispensable de s'assurer que de tels tests ne puissent pas conduire à des résultats positifs en dépit de la défaillance d'un composant.

Il existe un grand nombre de solutions de sécurité intrinsèque connus de l'homme du métier, notamment dans l'industrie de la signalisation ferroviaire. Il est par exemple possible, pour des entrées de circuits numériques, de recourir à des solutions de conception de circuits à fiabilité accrue, telles que des oscillateurs de Colpitts. Dans ce même domaine, il est possible de sécuriser des sorties de circuits numériques par le recours à des réseaux de relais à contacts interdépendants.

Néanmoins de telles solutions présentent des inconvénients. D'une part, la complexité des circuits électroniques à sécurité intrinsèque a pour conséquence des coûts de développement et de réalisation élevés. D'autre part, lorsqu'il est fait recours à des relais électromécaniques, ces derniers présentent un nombre de cycles d'opération limité, soit une durée de vie restreinte imposant des tests rapprochés dans le temps et le remplacement préventif de ces relais lors de procédures de maintenance. Il est à noter que ces inconvénients peuvent nuire à l'exhaustivité des tests ; en outre des tests trop intrusifs conduisent souvent à des perturbations du fonctionnement des dispositifs sous test pouvant représenter des menaces à leur sécurité.

Les documents EP0509920, JP11305823, JP11215835 et US5612582 divulguent des circuits comprenant des coupleurs photovoltaïques et des éléments photovoltaïques.

Un but de l'invention est de pallier les problèmes susmentionnés, en proposant un système à sécurité intrinsèque capable d'assurer une alimentation sûre et efficace des composants ou circuits sous test ou bien de circuits de test, et qui ne compromette pas le fonctionnement des dispositifs dans lesquels ils sont intégrés. Un autre avantage de l'invention est lié au faible volume requis pour sa mise en oeuvre dans des dispositifs, ainsi qu'au faible coût de cette dernière, tout en assurant un niveau de sécurité optimal. En outre le système selon l'invention permet le diagnostic de fuites de courant en provenance des composants ou circuits sous test, afin de déclencher le recours à des dispositifs de secours si des redondances ont été prévues, ou bien déclencher des alertes, des opérations de réparation si besoin, et tout simplement déclencher des mesures maximisant la sécurité, comme par exemple un signal invitant les trains à s'arrêter ; toutes ces actions étant par exemple contrôlées par un système central de contrôle. Enfin, un autre avantage de l'invention est de pouvoir s'appliquer aussi bien au test d'entrées ou de sorties de composants ou circuits sous test.

A cet effet, l'invention a pour objet un module de test d'un circuit électrique, caractérisé en ce qu'il comprend un moyen d'alimentation comprenant un coupleur photovoltaïque isolé qui, pendant le test, charge un moyen de stockage d'énergie qui se décharge dans le circuit électrique.

L'invention a aussi pour objet un système comportant une fonction de sécurité intrinsèque comprenant un tel module.

Dans un mode de réalisation de l'invention, le système comporte en outre des moyens de mesure d'un état de charge du moyen de stockage d'énergie.

Dans un mode de réalisation de l'invention, l'indicateur de l'état de charge est un temps représentatif du temps de décharge du moyen de stockage d'énergie.

Dans un mode de réalisation de l'invention, le système comprend en outre des moyens d'alerte activés en cas de franchissement d'une valeur de seuil prédéterminée par ledit indicateur de l'état de charge.

Dans un mode de réalisation de l'invention, le système est caractérisé en ce que le moyen de stockage d'énergie est un condensateur.

Dans un mode de réalisation de l'invention, le système est caractérisé en ce que ledit au moins un composant sous test est au moins un commutateur.

Dans un mode préféré de réalisation de l'invention, le commutateur est de type transistor à effet de champ.

L'invention a aussi pour objet un système de signalisation ferroviaire comprenant un système à sécurité intrinsèque tel que décrit ci-dessus.

Dans un mode de réalisation de l'invention, le module de test est caractérisé en ce qu'il comprend en outre des moyens de mesure d'un état de charge du moyen de stockage d'énergie.

Dans un mode préféré de réalisation de l'invention, le moyen de stockage de l'énergie est un condensateur.

L'invention a aussi pour objet un système de signalisation ferroviaire comportant une fonction de sécurité intrinsèque, comprenant au moins un réseau de commutateurs interconnectés, apte à commander l'alimentation d'une charge, caractérisé en ce que chacun des commutateurs du réseau est associé à un module de test tel que décrit ci-dessus.

Dans un mode de réalisation de l'invention, le système de signalisation ferroviaire est caractérisé en ce que ledit au moins un réseau de commutateurs interconnectés commandant la charge comprend deux réseaux de commutateurs de type transistors à effet de champ à canal P et transistors à effet de champ à canal N, chacun des réseaux comprenant deux branches parallèles, chacune des branches parallèles comprenant deux commutateurs de type transistors à effet de champ à canal P ou deux commutateurs de type transistors à effet de champ à canal N, chacun des réseaux étant connecté entre la borne positive ou négative d'une batterie et une des bornes de la charge.

D'autres caractéristiques et avantages de l'invention apparaîtront à la lecture de la description, donnée à titre d'exemple, faite en regard des dessins annexés qui représentent :
- la figure 1, le schéma électrique d'un exemple de mode de réalisation de l'invention appliqué à l'alimentation d'un circuit sous test ;
- la figure 2, le schéma électrique d'un exemple de mode de réalisation de l'invention s'appliquant à la détection de courants de fuite en provenance d'un composant ou circuit sous test ;
- les figures 3A et 3B, le schéma électrique d'un exemple de mode de réalisation de l'invention s'appliquant à la mesure de courants de fuite au niveau d'un actuateur de type transistor à effet de champ (ci-après désigné MOSFET) à canal N, et de type MOSFET à canal P respectivement ;
- la figure 4, le schéma électrique d'un exemple de mode de réalisation de l'invention s'appliquant à un réseau d'actuateurs de type MOSFET à canaux P et N ;
- la figure 5, le schéma électrique d'un exemple de mode de réalisation de l'invention s'appliquant à la sécurisation de l'entrée d'un circuit.

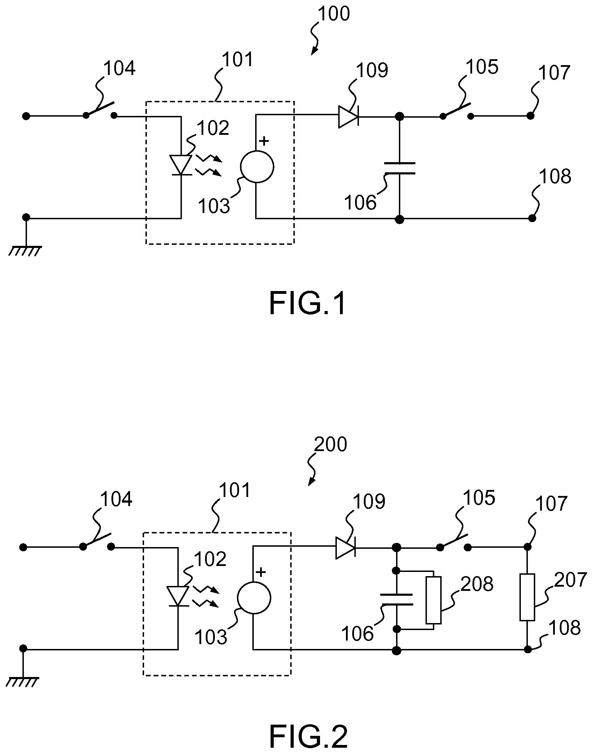

La figure 1 représente le schéma électrique d'un exemple de système à sécurité intrinsèque 100 selon l'invention appliqué à l'alimentation d'un circuit sous test ou un circuit de test, non représenté sur la figure. Ce circuit sous test est connecté à des bornes d'entrée 107 et 108. Le système selon l'invention comporte un coupleur photovoltaïque 101, comprenant un dispositif d'émission de lumière 102 et une cellule photovoltaïque 103 couplés optiquement mais galvaniquement isolés l'un de l'autre. Le coupleur photovoltaïque 101 est connecté entre un premier commutateur 104 et un potentiel de référence. Le commutateur 104, par exemple un actuateur, est connecté à une source d'énergie, par exemple une tension chargée par une résistance non représentée. Le coupleur photovoltaïque 101 constitue une source d'énergie, sa puissance étant limitée par les propriétés inhérentes à ce composant. Par exemple, la tension maximale aux bornes de la cellule est limitée à 10 Volts, et le courant délivré est de l'ordre de quelques micro-ampères. Un condensateur 106 est connecté entre les bornes de la cellule photovoltaïque 103, par exemple via une diode 109. Ce condensateur présente typiquement une capacité de l'ordre du microfarad. La diode 109 permet de protéger l'anode de la cellule photovoltaïque 103 des retours de courant électrique. Le condensateur 106 est connecté au circuit sous test par les bornes d'entrée 107 et 108. Un deuxième commutateur 105 est connecté entre une première armature du condensateur 106 et une première borne 107. La deuxième borne 108 est connectée à la seconde armature du condensateur 106. Le fonctionnement du système peut se décomposer en trois phases distinctes décrites ci-après.
- Une première phase de charge du condensateur 106. Dans cette première phase, le premier commutateur 104 est fermé et le deuxième commutateur 105 est ouvert. La puissance délivrée par la cellule photovoltaïque 103 est alors stockée sous forme d'énergie dans le condensateur 106. La durée de la première phase, de l'ordre de quelques secondes, est prédéterminée de manière à assurer la charge complète du condensateur 106.
- Une deuxième phase de décharge du condensateur 106. Dans cette deuxième phase, le premier commutateur 104 est ouvert, et le deuxième commutateur 105 est fermé. Durant une période de temps de l'ordre de quelques millisecondes par exemple, l'énergie stockée dans le condensateur 106 est utilisée pour alimenter le circuit sous test. L'impédance de sortie du circuit 100 est telle que la perturbation vis-à-vis du circuit sous test est de courte durée, et n'a ainsi aucun impact sur le bon fonctionnement du circuit sous test, ou bien cet impact peut être facilement éliminé par exemple au moyen de filtres appropriés connus de l'homme du métier, sans aucun préjudice à la fonctionnalité du circuit sous test.
- Dans une troisième phase, le premier commutateur 104 est ouvert, ainsi que le commutateur 105. Le système est alors inactif, et lorsqu'un nouveau test doit être réalisé, la séquence peut recommencer par la première phase. Il est à noter que la troisième phase est facultative, le système pouvant revenir à la première phase juste après la fin de la deuxième phase en tant que de besoin.

Un avantage de l'invention est que la puissance délivrée par le coupleur photovoltaïque 101 est limitée, et ne peut altérer le circuit sous test et mettre en cause la sécurité, même dans l'éventualité où les commutateurs 104 et 105 resteraient durablement fermés.

La figure 2 représente le schéma électrique d'un exemple de système à sécurité intrinsèque 200 selon l'invention appliqué à la détection de fuites de courant au niveau d'un circuit sous test, non représenté, connecté en parallèle avec un condensateur 106. Ce circuit sous test se comporte habituellement comme un circuit ouvert. La figure 2 diffère de la figure 1 en ce qu'une résistance 208, en parallèle avec le condensateur 106, représente la résistance de fuite de courant au niveau du circuit sous test. En outre, les bornes d'entrée 107 et 108 sont connectées à un dispositif de mesure de courant 207. Le fonctionnement du système peut se décomposer en deux phases distinctes décrites ci-après.
- Une première phase de charge du condensateur 106. Dans cette première phase, dont la durée est prédéterminée pour assurer une charge complète du condensateur 106, le premier commutateur 104 est fermé, et le deuxième commutateur 105 est ouvert. Le condensateur 106 se charge, de la même manière que précédemment décrite en référence à la figure 1. Cette fois, si une fuite est présente au niveau du circuit sous test, la résistance de fuite 208 absorbe une partie de la puissance électrique, et le condensateur 106 ne peut se charger que partiellement.
- Une deuxième phase de décharge du condensateur 106. Dans cette deuxième phase, le premier commutateur 104 est ouvert, et le deuxième commutateur 105 est fermé ; ainsi le condensateur 106 se décharge dans le dispositif de mesure 207. Ce dispositif peut par exemple comprendre des moyens pour mesurer la tension aux bornes du condensateur 106, ou bien des moyens pour mesurer un temps de décharge du condensateur, ou bien un temps au terme duquel la tension aux bornes du condensateur passe au-dessous d'un seuil prédéterminé. Il est bien entendu que d'autres moyens d'estimation de la charge du condensateur peuvent être envisagés.

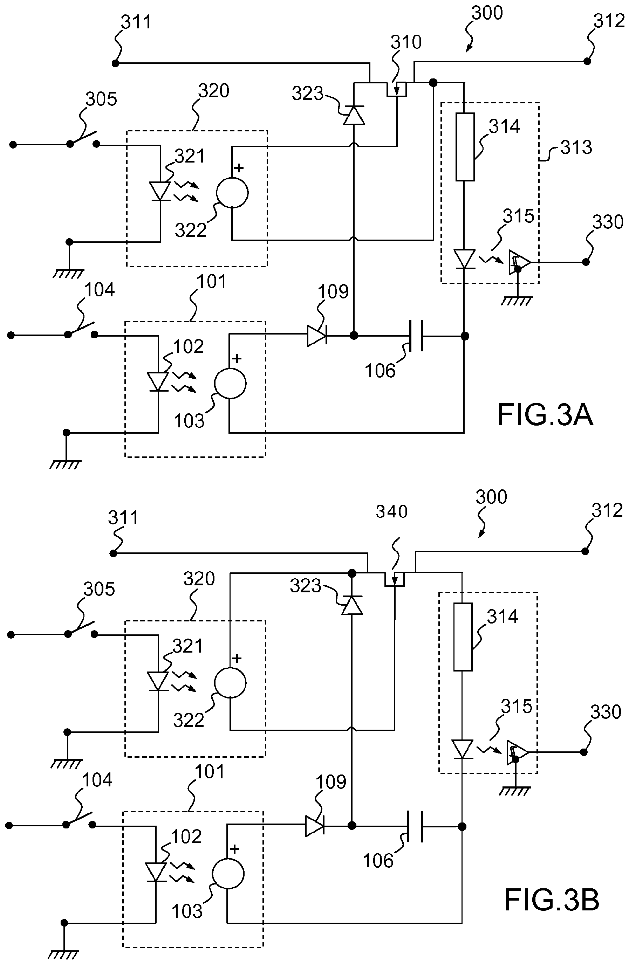

La figure 3A représente le schéma électrique d'un système à sécurité intrinsèque 300 selon l'invention, appliqué à titre d'exemple à la détection de courants de fuite au niveau d'un commutateur 310 de type MOSFET à canal N. Un premier coupleur photovoltaïque 320 comportant une source de lumière 321 couplé à une cellule photovoltaïque 322, est utilisé comme source d'énergie pour le commutateur 310. L'émetteur de lumière 321 est connecté à une source d'énergie via un premier commutateur 305, et à un potentiel de référence. La borne positive de la cellule photovoltaïque 322 est connectée à la grille du commutateur MOSFET 310. La borne négative de la cellule 322 est connectée à la source du commutateur MOSFET 310. Un deuxième coupleur photovoltaïque 101 comprenant un émetteur de lumière 102 couplé à une cellule photovoltaïque 103 est utilisé comme source d'énergie pour la charge d'un condensateur 106. L'émetteur de lumière 102 est connecté à une source d'énergie via un deuxième commutateur 104, et au potentiel de référence. La borne positive de la cellule photovoltaïque 103 est connectée à une diode 109. La diode 109 est connectée au drain du commutateur MOSFET 310 via une diode 323. Les diodes 109 et 323 protègent la cellule photovoltaïque 103 contre des retours de courant. La diode 109 est en outre connectée à la première armature d'un condensateur 106. La borne négative de la cellule photovoltaïque 103 est connectée à la seconde armature du condensateur 106. Le drain du commutateur MOSFET 310 est en outre connecté à une entrée 311, la source à une sortie 312. La source est en outre connectée à un dispositif de mesure de courant 313, dans cet exemple constitué d'une résistance 314 connecté au primaire d'un photocoupleur à trigger de Schmitt 315. Le secondaire de ce photocoupleur est connecté à une sortie de test 330. Le fonctionnement du système peut se décomposer en deux phases distinctes décrites ci-après.
- Dans une première phase, le premier commutateur 305 et donc le commutateur MOSFET 310 sont ouverts, et le deuxième commutateur 104 est fermé. Ainsi, d'une manière similaire à ce qui a été décrit plus haut en référence à la figure 2, le deuxième coupleur photovoltaïque 101 charge le condensateur 106, pendant une durée prédéterminée pour assurer une charge complète de celui-ci. Dans l'hypothèse où le commutateur MOSFET 310 présente des fuites de courant, la charge du condensateur 106 ne pourra être que partielle.
- Dans une seconde phase, le deuxième commutateur 104 est ouvert et le premier commutateur 305 est fermé. Le commutateur MOSFET 310 est alors fermé. Dans cet exemple, la sortie 330 est temporairement active, pendant une durée dépendant du courant électrique parcourant la résistance 314. Ainsi, un courant de fuite au niveau de l'actuateur 310 se traduit par une durée de l'état actif du photocoupleur 315 inférieure à un seuil prédéterminé. Il est bien entendu que d'autres types de dispositifs connus aptes à déterminer un état de la charge du condensateur 106 peuvent être envisagés.

La figure 3B est similaire à la figure 3A. Elle concerne le cas où le composant sous test est un commutateur de type MOSFET à canal P 340. La description faite en référence à la figure 3A s'applique à la figure 3B, excepté le fait que la borne positive de la cellule photovoltaïque 322 du premier coupleur 320 est connectée à la source du commutateur MOSFET 340. La borne négative de la cellule 322 est connectée à la grille du commutateur MOSFET 340.

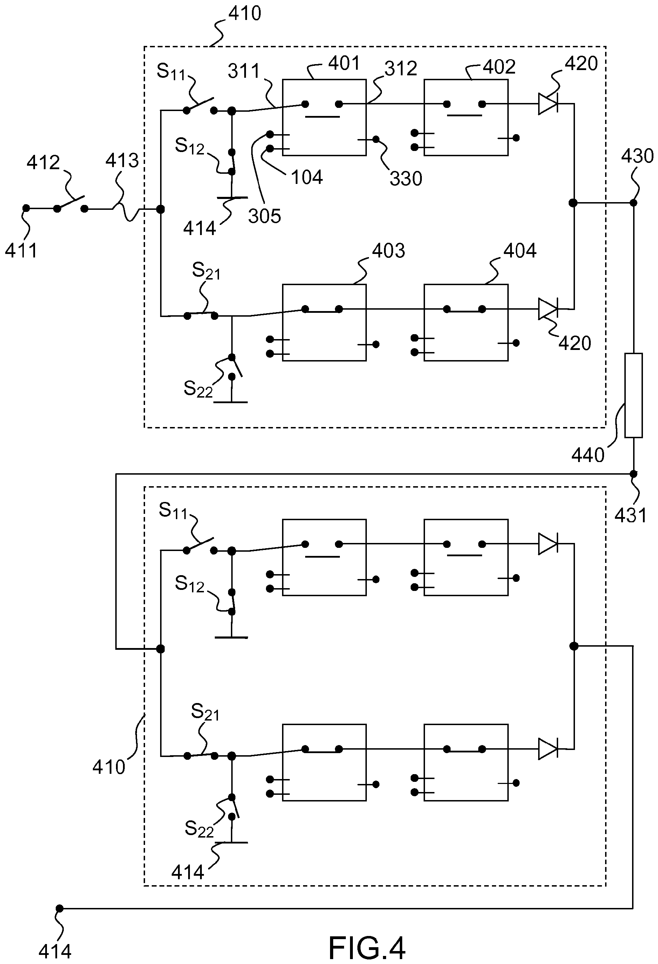

La figure 4 représente le schéma électrique d'un mode de réalisation de l'invention, s'appliquant à titre d'exemple à un système sécurisé de commande comprenant des commutateurs de type MOSFET à canaux P et N. Un système 400 selon l'invention comprend deux réseaux 410 de quatre modules 401, 402, 403 et 404 alimentés par une batterie et connectés à une charge 440. L'entrée du réseau 410 est connectée à la borne positive de la batterie via un relais de déconnexion 412 et un fusible 413. L'entrée du réseau 410 est en outre connectée à deux branches parallèles, chacune d'entre elles comprenant deux modules connectés en série. Une première branche parallèle comprend le premier module 401, dans cet exemple un système comprenant un commutateur de type MOSFET à canal N tel que représenté sur la figure 3A, en série avec le deuxième module 402, comprenant un commutateur de type MOSFET à canal P tel que représenté sur la figure 3B, le deuxième module étant monté en série avec une diode de protection 420. Deux commutateurs S11 et S12 sont connectés entre l'entrée du réseau 410 et l'entrée du premier module 401. Le premier commutateur S11 est connecté entre l'entrée du réseau 410 et une borne du deuxième commutateur S12. L'autre borne du deuxième commutateur S12 est connectée à la borne négative 414 de la batterie. La sortie du premier module 401 est connectée à l'entrée du deuxième module 402. La sortie du deuxième module 402 est connectée à une première borne 430 de la charge 440. Une seconde branche parallèle comprend le troisième module 403, dans cet exemple un système comprenant un commutateur de type MOSFET à canal P tel que représenté sur la figure 3B, en série avec le quatrième module 404, comprenant un commutateur de type MOSFET à canal N tel que représenté sur la figure 3A, le quatrième module étant monté en série avec une diode de protection 420. Deux commutateurs S21 et S22 sont connectés entre l'entrée du réseau 410 et l'entrée du troisième module 403. Le premier commutateur S21 est connecté entre l'entrée du réseau 410 et une borne du deuxième commutateur S22. L'autre borne du deuxième commutateur S22 est connectée à la borne négative 414 de la batterie. La sortie du troisième module 403 est connectée à l'entrée du quatrième module 404. La sortie du quatrième module 404 est connectée à la première borne 430 de la charge 440. Une seconde borne 431 de la charge 440 est connectée à l'entrée d'un second réseau 410, dont la sortie est connectée à la borne négative 414 de la batterie. Chacun des modules 401, 402, 403 et 404 présente une entrée 311, une sortie 312, un premier commutateur 305 et un deuxième commutateur 104, et une sortie de test 330, selon les descriptions fournies en référence aux figures 3A et 3B. Chacun de ces modules est ainsi apte à être testé indépendamment des autres modules. Ainsi, toute défaillance d'un des dispositifs constituant ce système pourra être diagnostiquée rapidement.

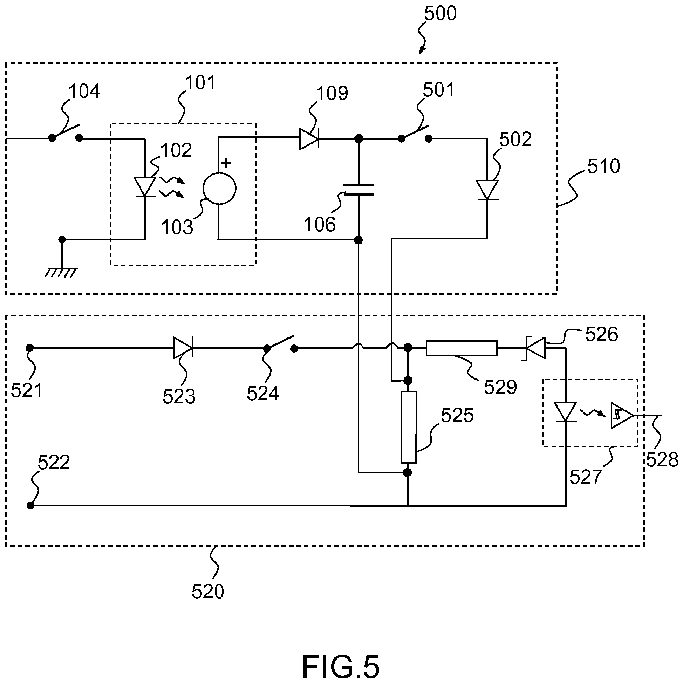

La figure 5 représente le schéma électrique d'un mode de réalisation de l'invention, s'appliquant à titre d'exemple au test de l'entrée d'un système électrique. Un tel système à sécurité intrinsèque selon l'invention comprend un circuit 520 et un module de test 510. Avantageusement, le module de test 510 est intégré au circuit 520. L'entrée 521 du circuit 520 est testée par le module de test 510. L'entrée 521 est connectée à un premier commutateur 524 via une diode de protection 523. Le premier commutateur 524 est en outre connecté à une diode Zener 526. La diode Zener 526 est destinée à fournir un seuil de tension au primaire d'un coupleur à trigger de Schmitt 527. Le secondaire de ce coupleur est connecté à une sortie 528. Le primaire du coupleur 527 est relié à un potentiel de référence 522. Une résistance de ligne 529 est connectée à la diode 526, juste en amont de celle-ci. Une résistance 525 fixe l'impédance d'entrée. Le module de test 510 est similaire aux systèmes décrits plus haut en référence aux figures précédentes. Ce module de test comprend donc un coupleur photovoltaïque 101 utilisé comme source d'énergie pour la charge d'un condensateur 106. Le coupleur photovoltaïque 101 comprend un émetteur de lumière 102 connecté à une source d'énergie via un second commutateur 104, et au potentiel de référence. L'émetteur de lumière 102 est couplé à une cellule photovoltaïque 103. La borne positive de la cellule photovoltaïque 103 est connectée à une diode 109. La diode 109 est connectée à la première armature d'un condensateur 106. La borne négative de la cellule 103 est connectée à la seconde armature du condensateur 106. Cette dernière est en outre connectée à une première borne de la résistance 525. La première armature du condensateur 106 est en outre connectée à la première borne d'un troisième commutateur 501. La seconde borne du commutateur 501 est connectée à la seconde borne de la résistance 525 via une diode de protection 502. Le fonctionnement du système peut se décomposer en deux phases distinctes décrites ci-après.
- Dans une première phase, le troisième commutateur 501 est ouvert ; ainsi le module de test 510 est déconnecté du circuit 520. Le premier commutateur 524 est fermé. Ainsi l'entrée 521 est lue et transmise à la sortie 528. Le deuxième commutateur 104 est fermé, donc le condensateur 106 se charge.
- Dans une seconde phase, le deuxième commutateur 104 est ouvert. Le premier commutateur 524 est ouvert, et la sortie 528 devient inactive. Le troisième commutateur 501 est fermé, ainsi le condensateur 106 se décharge dans le circuit 520. Il en résulte une impulsion sur la sortie 528. Des moyens de mesure, non représentés ici, permettent de caractériser cette impulsion. Par exemple, en mesurant la durée de l'impulsion, il est possible de détecter l'augmentation de la résistance 525, ainsi qu'une modification du seuil de tension d'entrée, conditionné par la diode Zener 526.

## Revendications

1. Module de test d'un circuit électrique, **caractérisé en ce qu'**il comprend au moins un moyen d'alimentation comprenant un coupleur photovoltaïque isolé (101) qui, pendant le test, charge un moyen de stockage d'énergie (106) qui se décharge dans le circuit électrique.

2. Module de test d'un circuit électrique selon la revendication 1, **caractérisé en ce qu'**il comprend en outre des moyens de mesure (207) d'un état de charge du moyen de stockage d'énergie (106).

3. Module de test selon l'une quelconque des revendications 1 et 2, **caractérisé en ce que** le moyen de stockage d'énergie est un condensateur (106).

4. Système de signalisation ferroviaire (400) comportant une fonction de sécurité intrinsèque, comprenant au moins un réseau de commutateurs interconnectés (410), apte à commander l'alimentation d'une charge (441), **caractérisé en ce que** chacun des commutateurs du réseau est associé à un module de test selon l'une quelconque des revendications 1 à 3.

5. Système de signalisation ferroviaire (400) selon la revendication 4, **caractérisé en ce que** ledit au moins un réseau de commutateurs interconnectés (410) commandant la charge (441) comprend deux réseaux de commutateurs de type transistors à effet de champ à canal P et transistors à effet de champ à canal N, chacun des réseaux comprenant deux branches parallèles, chacune des branches parallèles comprenant deux commutateurs de type transistors à effet de champ à canal P ou deux commutateurs de type transistors à effet de champ à canal N, chacun des réseaux étant connecté entre la borne positive (411) ou négative (414) d'une batterie et une des bornes (430, 431) de la charge (441).

6. Système (100) comportant une fonction de sécurité intrinsèque comprenant au moins un module de test d'un circuit selon la revendication 1, le test du circuit comprenant au moins une première phase de charge du moyen de stockage d'énergie (106), et une deuxième phase de décharge du moyen de stockage d'énergie (106).

7. Système à sécurité intrinsèque selon la revendication 6, **caractérisé en ce qu'**il comporte en outre des moyens de mesure (207) d'un état de charge du moyen de stockage d'énergie.

8. Système à sécurité intrinsèque selon la revendication 7, **caractérisé en ce que** ledit indicateur de l'état de charge est un temps représentatif du temps de décharge du moyen de stockage d'énergie.

9. Système à sécurité intrinsèque selon l'une quelconque des revendications 7 et 8, **caractérisé en ce qu'**il comprend en outre des moyens d'alerte activés en cas de franchissement d'une valeur de seuil prédéterminée par ledit indicateur de l'état de charge.

10. Système à sécurité intrinsèque selon l'une quelconque des revendications 6 à 9, **caractérisé en ce que** ledit moyen de stockage d'énergie (106) est un condensateur.

11. Système à sécurité intrinsèque selon l'une quelconque des revendications 6 à 10, **caractérisé en ce que** ledit au moins un composant sous test est au moins un commutateur (310).

12. Système à sécurité intrinsèque selon l'une quelconque des revendications 6 à 11, **caractérisé en ce que** ledit au moins un composant sous test est au moins un commutateur (310) de type transistor à effet de champ.

13. Système de signalisation ferroviaire comprenant un système à sécurité intrinsèque selon l'une quelconque des revendications 6 à 12.

## Patentansprüche

1. Testmodul für einen elektrischen Schaltkreis, **dadurch gekennzeichnet, dass** es mindestens ein Stromversorgungsmittel beinhaltet, welches einen isolierten Photovoltaikkoppler (101) beinhaltet, welcher während des Tests ein Energiespeichermittel (106) lädt, welches sich in den elektrischen Schaltkreis entlädt.

2. Testmodul für einen elektrischen Schaltkreis nach Anspruch 1, **dadurch gekennzeichnet, dass** es zudem Messmittel (207) eines mittleren Ladezustands des Energiespeichermittels (106) beinhaltet.

3. Testmodul nach einem der Ansprüche 1 und 2, **dadurch gekennzeichnet, dass** das Energiespeichermittel ein Kondensator (106) ist.

4. Eisenbahn-Signalsystem (400), beinhaltend eine Eigensicherheitsfunktion, beinhaltend mindestens ein Netzwerk aus miteinander verschalteten Umschaltern (410), in der Lage, die Stromversorgung einer Last (441) zu steuern, **dadurch gekennzeichnet, dass** jeder der Umschalter des Netzwerks mit einem Testmodul nach einem der Ansprüche 1 bis 3 assoziiert ist.

5. Eisenbahn-Signalsystem (400) nach Anspruch 4, **dadurch gekennzeichnet, dass** das mindestens eine Netzwerk aus miteinander verschalteten Umschaltern (410), welches die Last (441) steuert, zwei Netzwerke aus Umschaltern vom Typ Feldeffekttransistoren mit P-Kanal und Feldeffekttransistoren mit N-Kanal beinhaltet, wobei jedes der Netzwerke zwei parallele Arme beinhaltet, wobei jeder der parallelen Arme zwei Umschalter vom Typ Feldeffekttransistoren mit P-Kanal oder zwei Umschalter vom Typ Feldeffekttransistoren mit N-Kanal beinhaltet, wobei jedes der Netzwerke zwischen der positiven Klemme (411) oder der negativen Klemme (414) einer Batterie und einer der Klemmen (430, 431) der Last (441) angeschlossen ist.

6. System (100), beinhaltend eine Eigensicherheitsfunktion, welche mindestens ein Testmodul für einen Schaltkreis nach Anspruch 1 beinhaltet,
wobei der Schaltkreistest mindestens eine erste Phase des Ladens des Energiespeichermittels (106) und eine zweite Phase des Entladens des Energiespeichermittels (106) beinhaltet.

7. Eigensicheres System nach Anspruch 6, **dadurch gekennzeichnet, dass** es zudem Messmittel (207) eines mittleren Ladezustands der Energiespeichermittels beinhaltet.

8. Eigensicheres System nach Anspruch 7, **dadurch gekennzeichnet, dass** der Ladezustandsanzeiger eine Zeit ist, welche die mittlere Entladezeit des Energiespeichermittels darstellt.

9. Eigensicheres System nach einem der Ansprüche 7 und 8, **dadurch gekennzeichnet, dass** es zudem Alarmierungsmittel beinhaltet, welche bei Überschreitung eines durch den Ladezustandsanzeiger vorbestimmten Schwellenwertes aktiviert wird.

10. Eigensicheres System nach einem der Ansprüche 6 bis 9, **dadurch gekennzeichnet, dass** das Energiespeichermittel (106) ein Kondensator ist.

11. Eigensicheres System nach einem der Ansprüche 6 bis 10, **dadurch gekennzeichnet, dass** die mindestens eine getestete Komponente mindestens ein Umschalter (310) ist.

12. Eigensicheres System nach einem der Ansprüche 6 bis 11, **dadurch gekennzeichnet, dass** die mindestens eine getestete Komponente mindestens ein Umschalter (310) vom Typ Feldeffekttransistor ist.

13. Eisenbahn-Signalsystem, beinhaltend ein eigensicheres System nach einem der Ansprüche 6 bis 12.

## Claims

1. An electrical circuit test module, **characterized in that** it comprises at least one power supply means comprising an insulated photovoltaic coupler (101), which, during the test, charges an energy storage means (106), which is discharged into the electric circuit.

2. An electrical circuit test module according to claim 1, **characterized in that** it further comprises means of measuring (207) a state of charge of the energy storage means (106).

3. A test module according to any one of claims 1 and 2, **characterized in that** the power supply means is a capacitor (106).

4. A railroad signaling system (400) including a fail-safe function, comprising at least one network of interconnected switches (410), able to control the power supply to a load (441), **characterized in that** each of the switches of the network is associated with a test module as claimed in any one of claims 1 to 3.

5. The railroad signaling system (400) according to claim 4, **characterized in that** said at least one network of interconnected switches (410) controlling the load (441) comprises two networks of switches of P-channel field-effect transistor type and N-channel field-effect transistor type, each of the networks comprising two parallel branches, each of the parallel branches comprising two switches of P-channel field-effect transistor type or two switches of N-channel field-effect transistor type, each of the networks being connected between the positive (411) terminal or negative (414) terminal of a battery and one of the terminals (430, 431) of the load (441).

6. A system (100) including a fail-safe function comprising at least one circuit test module according to claim 1, the test module comprising at least one first phase of charging the energy storage means (106), and a second phase of discharging the energy storage means (106)

7. The fail-safe system according to claim 6, **characterized in that** it further comprises means of measuring (207) a state of charge of the energy storage means.

8. The fail-safe system according to claim 7, **characterized in that** said indicator of the state of charge is a time representative of the time of discharge of the energy storage means.

9. The fail-safe system according to any one of claims 7 and 8, **characterized in that** it further comprises warning means activated if a predetermined threshold value is crossed by the indicator of the state of charge.

10. The fail-safe system according to any one of claims 6 to 9, **characterized in that** said energy storage means (106) is a capacitor.

11. The fail-safe system according to any one of claims 6 to 10, **characterized in that** said at least one component under test is at least one switch (310).

12. The fail-safe system according to any one of claims 6 to 11, **characterized in that** said at least one component under test is at least one switch (310) of field-effect transistor type.

13. A railroad signaling system comprising a fail-safe system according to any one of claims 6 to 12.
